Europäisches Patentamt

European Patent Office

Office européen des brevets

(19)

(11) Numéro de publication: **0 269 485 B1**

# FASCICULE DE BREVET EUROPEEN

(12)

(45) Date de publication de fascicule du brevet: **18.03.92**

(51) Int. Cl.⁵: **G01K 17/20**, G01K 7/02, H01L 35/08, H01L 35/32

(21) Numéro de dépôt: **87402415.1**

(22) Date de dépôt: **27.10.87**

(54) **Dispositif de mesure formant un fluxmètre et un capteur de température combinés, constitué d'une structure multicouche, procédé de fabrication d'un tel dispositif et structure multicouche.**

(30) Priorité: **05.11.86 FR 8615427**

(43) Date de publication de la demande:
**01.06.88 Bulletin 88/22**

(45) Mention de la délivrance du brevet:
**18.03.92 Bulletin 92/12**

(84) Etats contractants désignés:
**AT BE CH DE FR GB IT LI LU SE**

(56) Documents cités:
**FR-A- 2 536 536**
**US-A- 3 554 815**
**US-A- 4 050 302**
**US-A- 4 197 738**

**PATENT ABSTRACTS OF JAPAN, vol. 7, no. 84 (E-169)[1229], 8 avril 1983; & JP-A-58 10 875**

**PATENT ABSTRACTS OF JAPAN, vol. 7, no. 54 (P-180)[1199], 4 mars 1983; & JP-A-57 200 828**

**PATENT ABSTRACTS OF JAPAN, vol. 9, no.**

**127 (P-360)[1850], 31 mai 1985; & JP-A-60 10 137**

**MESURES - REGULATION - AUTOMATISME, vol. 46, novembre 1981, pages 65-72; M. POR-TAT et al.: "Les capteurs pelliculaires et leurs applications"**

(73) Titulaire: **CENTRE SCIENTIFIOUE ET TECHNI-OUE DU BATIMENT**
**4, avenue du Recteur Poincaré**
**F-75782 Paris Cédex 16(FR)**

(72) Inventeur: **Sallee, Hébert**
**10, rue Charles Ferré**
**F-38400 St Martin D'Heres(FR)**
Inventeur: **Ouenard, Daniel**
**19, Allée des Myosotis**
**F-38610 Gieres(FR)**

(74) Mandataire: **Portal, Gérard et al**
**Cabinet Beau de Loménie 55, rue d'Amster-dam**
**F-75008 Paris(FR)**

EP 0 269 485 B1

## Description

L'invention concerne un dispositif de mesure formant un fluxmètre et un capteur de température combinés, constitué d'une structure multicouche. L'invention se rapporte également à un procédé de fabrication d'un tel dispositif et à une structure multicouche.

On connaît déjà par le document FR-2 536 536 un dispositif de mesure formant fluxmètre thermique à thermocouples, comprenant un substrat en matière isolante sur une face duquel est déposée une couche mince ininterrompue en une première matière conductrice ou semi-conductrice recouverte sur au moins sa face opposée audit substrat en matière isolante par une succession de zones, séparées les unes des autres, et disposées en rangées successives, constituées par des dépôts très minces d'une seconde matière conductrice ou semi-conductrice ayant un pouvoir thermoélectrique différent de celui de la première matière conductrice ou semi-conductrice. Selon une caractéristique préférée décrite dans ce document, au moins un canal traverse de part en part chaque zone et la couche mince sous-jacente, ces canaux étant décalés par rapport au centre de chaque zone traversée avantageusement dans le même sens, lesdits canaux pouvant être revêtus intérieurement d'un dépôt de la seconde matière. Selon une autre caractéristique préférée, la couche ininterrompue a la forme d'une bande avantageusement méandriforme pour pouvoir être repliée pour former une structure rectangulaire ou carrée (voir revendications 3 et 4).

On obtient de cette manière plusieurs centaines de thermocouples élémentaires, cette structure multicouche constituant alors un fluxmètre thermique. Selon une autre variante de réalisation, objet des figures 5 et 6 de FR-A-2 536 536, les zones en la seconde matière peuvent être réalisées sur chacune des faces de la couche mince ininterrompue.

Le procédé de préparation d'une telle structure multicouche est décrit plus particulièrement à la page 6, lignes 5 à 33 et comprend le collage d'une feuille de constantan sur un support formé par une plaque en matière plastique, suivi de l'attaque par la technique classique de gravure utilisée pour la fabrication des circuits imprimés, de la feuille de constantan le long de lignes parallèles formant deux peignes imbriqués de manière à définir la couche mince ininterrompue en forme de bande méandriforme. Sur cette bande méandriforme, on dépose par voie électrolytique des couches de cuivre épaisses de quelques microns après avoir protégé, au moyen d'une couche de résine photosensible, les portions ne devant pas être cuivrées, de manière à définir les zones précitées. Ensuite, on procède à une gravure de trous par attaque chimique, ces trous étant ensuite revêtus intérieurement d'une couche en la seconde matière conductrice ou semi-conductrice, notamment en cuivre.

Enfin, on peut recouvrir la face supérieure du dispositif au moyen d'une couche d'une résine thermodurcissable protégeant le cuivre et le constantan de l'oxydation.

On connaît encore par le document JP-A-58-10875 Toshiba un procédé de fabrication de thermocouples conformés en feuille. La structure de ces thermocouples comprend un film support en résine thermiquement résistante, par exemple un film de résine de polyimide, dont une surface est recouverte d'une couche de cuivre, tandis que la surface opposée est recouverte d'une couche de constantan, les deux couches métalliques étant ensuite soumises à une attaque de manière à laisser la partie de fil conducteur.

Ensuite, des trous traversants sont réalisés au travers des parties d'extrémité des deux parties de conducteur et du cuivre et plaqués à l'intérieur de l'orifice, de manière à connecter les parties de fil conducteur en cuivre et en constantan.

Par ailleurs, le document US 3 554 815 Du Pont de Nemours décrit encore une thermopile basée sur la combinaison de thermocouples individuels disposés de part et d'autre d'un substrat isolant thermiquement résistant et connectés entre eux par des orifices traversants qui sont ensuite remplis de soudure. La forme des thermocouples est obtenue par des procédures de placage et des techniques de photogravure.

Les thermocouples sont montés en série. Comme matériau support, on cite des plaques de résine époxy renforcée aux fibres de verre, des laminés de telles plaques, des plaques de résine de polyester insaturé renforcé aux fibres de verre, des laminés de telles plaques, une plaque laminée de résine phénolique-papier et analogue (colonne 4, lignes 28 à 36).

Des dispositifs formant fluxmètre à base d'une structure multicouche, de structure plus éloignée sont également décrits dans US-A-4 050 302 et FR-A-2 413 646 = US-A-4 197 738.

On constate ainsi que, selon les dispositifs antérieurement connus, ceux-ci sont soit constitués par des structures multicouches formant fluxmètre, soit par des structures multicouches incluant un ou plusieurs thermocouples formant des dispositifs de détecteur de température.

Là où on désire procéder à la mesure du flux thermique et à la mesure de la température, ce qui est habituellement nécessaire, il y a lieu d'utiliser des dispositifs distincts qui sont donc insérés en des endroits différents, ce qui peut conduire à des corrections de mesure.

La présente invention a pour but de résoudre le nouveau problème technique consistant en la fourniture d'une structure multicouche réalisée de façon à constituer un dispositif de mesure formant un fluxmètre et un capteur de température combinés, de sorte que l'insertion d'un dispositif unique permette de mesurer le flux thermique et la température.

La présente invention a aussi pour but de résoudre le nouveau problème technique consistant en la fourniture d'une structure multicouche réalisée de façon à permettre la détection du flux thermique et de la température dans un même plan.

Ces problèmes techniques sont résolus de manière satisfaisante par la présente invention.

Ainsi, selon un premier aspect, la présente invention fournit un dispositif de mesure formant un fluxmètre et un capteur de température combinés, constitué d'une structure multicouche, comprenant un substrat en matière isolante sur une face duquel est déposée une couche mince ininterrompue en une première matière conductrice ou semi-conductrice recouverte sur au moins sa face opposée audit substrat en matière isolante par une succession de zones, séparées les unes des autres et disposées en rangées successives, constituées par des dépôts très minces d'une deuxième matière conductrice ou semi-conductrice ayant un pouvoir thermoélectrique différent de celui de la première matière conductrice ou semi-conductrice, caractérisé en ce que ledit substrat isolant comprend sur sa face comportant ladite couche mince ininterrompue un certain nombre d'espaces libres dans au moins certains desquels sont réalisés un certain nombre de premiers motifs métalliques en une troisième matière conductrice ou semi-conductrice, constituant une première branche d'un thermocouple, un nombre égal de seconds motifs métalliques en une quatrième matière conductrice ou semi-conductrice à pouvoir thermoélectrique différent de ladite troisième matière, constituant une seconde branche d'un thermocouple, est disposé sur la face du substrat isolant opposée à ladite couche mince et auxdits premiers motifs, chaque premier motif est en contact avec un second motif correspondant par une soudure métallique ponctuelle réalisée dans un orifice traversant au moins ledit premier motif et ledit substrat.

Selon un mode de réalisation avantageux, la soudure est réalisée par métallisation et recouvre ledit premier motif sur une surface déterminée autour de l'orifice en formant ainsi une couche métallique de solidarisation mécanique de ladite soudure.

Selon un mode de réalisation préféré, la troisième matière conductrice ou semi-conductrice constituant les premiers motifs et la première matière conductrice ou semi-conductrice constituant la couche mince ininterrompue précitée sont réalisées en la même matière conductrice ou semi-conductrice. Selon un autre mode de réalisation préféré, la soudure métallique est réalisée en la même matière conductrice ou semi-conductrice constituant les zones précitées. Selon un mode de réalisation particulier, au moins un canal traverse de part en part au moins la plupart des zones précitées et la couche mince sous-jacente, ces canaux étant décalés par rapport au centre de chaque zone traversée.

Selon une réalisation particulière, les canaux sont décalés entre eux de part et d'autre du centre de chaque zone traversée entre deux rangées successives ou adjacentes. Selon encore une autre caractéristique de l'invention, la structure multicouche comprend une feuille mince en une cinquième matière conductrice ou semi-conductrice appliquée contre l'autre face du substrat isolant opposée à la face comportant la couche mince ininterrompue avec les zones précitées, comportant des espaces pour les seconds motifs précités. Ces seconds motifs sont réalisés de préférence en la même matière conductrice ou semi-conductrice que la feuille. Selon un mode de réalisation particulier, avantageux, la couche mince ininterrompue et les premiers motifs sont réalisés en constantan, tandis que la feuille et les seconds motifs sont réalisés en cuivre. Selon une autre réalisation particulière, cette structure multicouche comprend en outre une feuille de matière isolante, non conductrice de l'électricité, appliquée contre les zones précitées, cette feuille de matière isolante étant recouverte d'une feuille en une sixième matière conductrice ou semi-conductrice sur sa face opposée aux zones précités, cette sixième matière conductrice ou semi-conductrice étant identique à la cinquième matière conductrice ou semi-conductrice.

Selon une autre réalisation particulière, la couche mince ininterrompue a la forme d'une bande méandriforme et définit ainsi les rangées successives précitées. On comprend ainsi que l'on obtient tous les avantages techniques précédemment énoncés, a savoir la combinaison d'un fluxmètre et d'un capteur de température. En outre, ce fluxmètre et ce capteur de température étant réalisés dans la même structure multicouche, les mesures sont réalisées dans le même plan, ce qui améliore leur précision. En outre, par la présence des feuilles en une cinquième matière conductrice ou semi-conductrice et en une sixième matière conductrice ou semi-conductrice isolées électriquement de la couche mince ininterrompue définissant le fluxmètre thermique, on répartit uniformément le flux et, surtout, une de ces feuilles de répartition uniforme du flux est constituée par celle qui comporte les seconds motifs précités et qui constitue une partie intégrante du capteur de température. On obtient ainsi une simplification radicale de la conception du fluxmètre et du capteur combinés, conduisant elle aussi à une simplification remarquable du procédé de fabrication d'une telle structure multicouche constituant un dispositif de mesure formant fluxmètre et capteur de température combinés.

La présente invention concerne aussi un dispositif de mesure formant un fluxmètre et un capteur de température combinés tel que précédemment défini, caractérisé en ce que les extrémités de la couche mince ininterrompue précitée sont reliées entre elles par l'intermédiaire d'un appareillage formant fluxmètre et mesurant la force électromotrice en fonction du flux thermique traversant la structure multicouche tandis que les premiers motifs sont reliés aux seconds motifs par un appareillage formant détecteur de température et mesurant la force électromotrice en fonction de la température.

Selon une autre variante de réalisation, la structure multicouche précitée est flexible, en particulier par l'emploi d'un substrat flexible.

Aussi, selon un second aspect, la présente invention fournit un procédé de préparation de la structure multicouche utilisée dans le dispositif de mesure formant fluxmètre et capteur de température combinés, comprenant :

- la prévision d'un substrat en matière isolante, sous forme d'une feuille ;
- l'application sur une face dudit substrat d'une première couche mince continue de la première matière conductrice ou semi-conductrice précitée ;
- l'apposition de masques déterminés sur la première couche recouvrant le substrat, définissant des lignes d'attaque de ladite couche ;
- l'attaque de ladite couche par trempage de l'ensemble avec les masques dans une solution d'attaque par la technique classique de gravure de manière à attaquer la première couche selon certaines lignes, en définissant ainsi dans la première couche une couche ininterrompue ;
- le dépôt par métallisation sur au moins la face de ladite couche mince ininterrompue opposée au substrat, d'une succession de zones, séparées les unes des autres, et disposées en rangées successives, constituées par des dépôts très minces d'une deuxième matière conductrice ou semi-conductrice ayant un pouvoir thermoélectrique différent de celui de la première matière conductrice ou semi-conductrice ;

caractérisé en ce qu'on réalise l'attaque de ladite première couche avec des masques selon des lignes définissant dans la première couche, outre ladite couche ininterrompue, un certain nombre d'espaces libres dans au moins certains desquels sont réalisés un certain nombre de premiers motifs métalliques en une troisième matière conductrice ou semi-conductrice constituant une première branche d'un thermocouple, on applique sur l'autre face du substrat opposée à la première couche une deuxième couche mince continue en une quatrième matière conductrice ou semi-conductrice à pouvoir thermoélectrique différent de celui-ci de la troisième matière conductrice ou semi-conductrice, on réalise l'attaque de la deuxième couche avec les masques selon des lignes définissant, dans la deuxième couche, un nombre égal de seconds motifs métalliques en ladite quatrième matière ou semi-conductrice, constituant une deuxième branche d'un thermocouple, dans des espaces libres correspondants ; on réalise des orifices traversant au moins les premiers motifs et ledit substrat en matière isolante ; et on réalise une soudure métallique ponctuelle dans chaque orifice mettant en contact chaque premier motif avec un second motif correspondant.

Selon une réalisation avantageuse du procédé selon l'invention, on applique sur la face comportant les zones précitées une feuille en matière isolante et ensuite une feuille conductrice ou semi-conductrice, en une cinquième matière conductrice ou semi-conductrice.

Selon un troisième aspect, la présente invention concerne une structure multicouche, caractérisée en ce que ledit substrat en matière isolante comprend sur sa face comportant ladite couche mince ininterrompue un certain nombre d'espaces libres dans au moins certains desquels sont réalisés un certain nombre de premiers motifs métalliques en une troisième matière conductrice ou semiconductrice constituant une première branche d'un thermocouple, un nombre égal de seconds motifs métalliques correspondant en une quatrième matière conductrice ou semi-conductrice à pouvoir thermoélectrique différent de celui de la troisième matière conductrice ou semiconductrice, constituant une deuxième branche d'un thermocouple, est disposé sur la face du substrat isolant opposée à la couche mince ininterrompue et aux premiers motifs, chaque premier motif est en contact avec un second motif correspondant par une soudure métallique ponctuelle réalisée dans un orifice traversant au moins ledit premier motif et ledit substrat en matière isolante.

L'invention apparaîtra clairement à la lumière de la description explicative qui va suivre faite en référence aux dessins annexés, dans lesquels :

- la figure 1 est une vue partiellement éclatée du dispositif de mesure formant un fluxmètre et un capteur de température combinés, constitué d'une structure multicouche, selon la présente invention permettant de voir clairement la face comportant le fluxmètre et une partie du capteur de température ;
- la figure 2 est une vue de dessus de cette même face, sur une grande surface ;
- la figure 2a est une vue de détail montrant les cellules individuelles du fluxmètre et un motif du capteur de température ; et
- la figure 3 représente une vue de dessous du dispositif selon la flèche III de la figure 1.

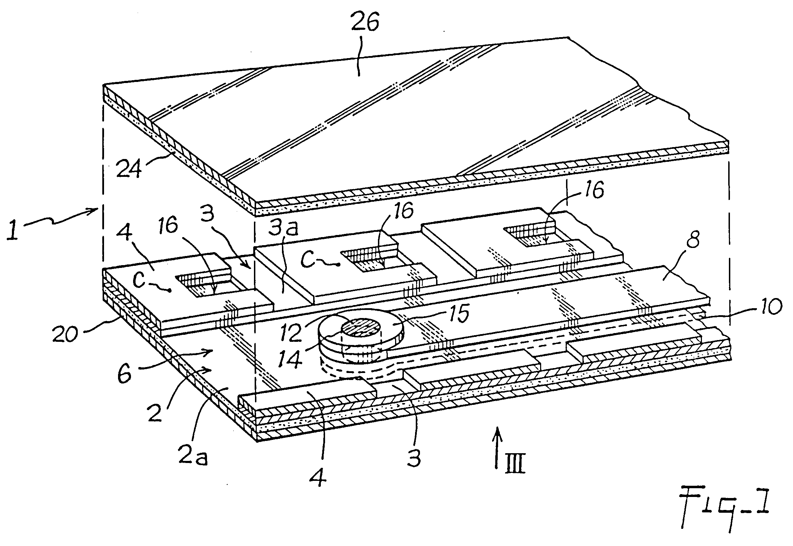

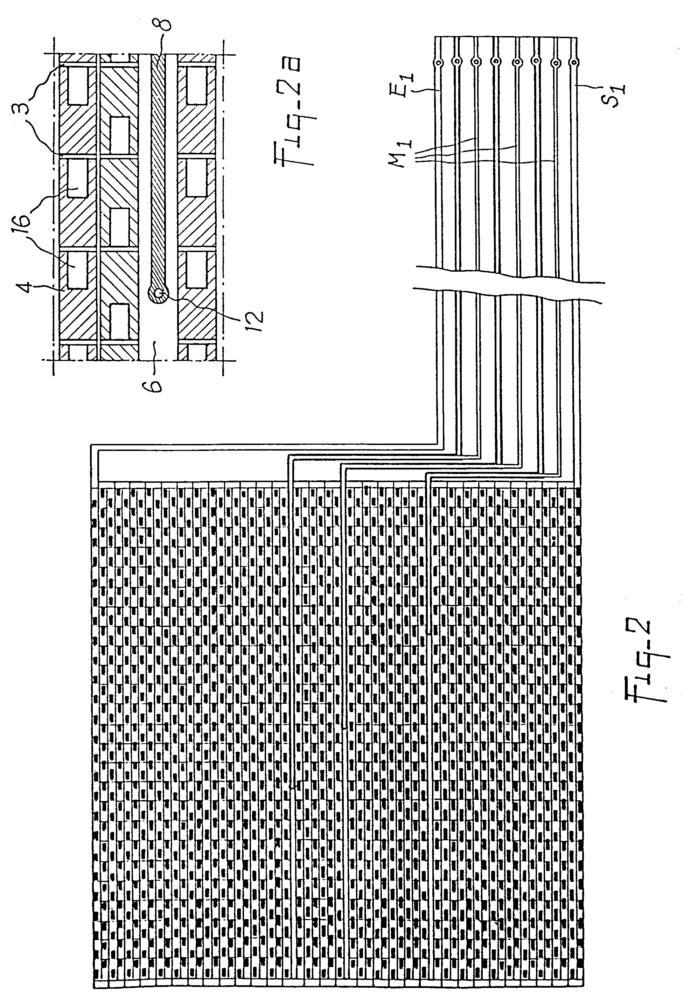

En référence aux figures 1 à 3, un dispositif de mesure formant un fluxmètre et un capteur de température combinés, constitué d'une structure multicouche selon l'invention, représenté par le numéro de référence générale 1, de préférence flexible, comprend :
- un substrat 2 en matière isolante, c'est-à-dire en matière non conductrice de l'électricité, comme par exemple un polyimide ou une résine époxy. Ce substrat peut se présenter éventuellement sous forme d'une feuille qui présente l'avantage d'être flexible et de rendre la structure multicouche flexible ;
- sur une face, ici la face supérieure 2a, est déposée une couche mince ininterrompue 3 en une première matière conductrice ou semi-conductrice ;
- cette couche mince ininterrompue 3 est recouverte sur au moins sa face 3a opposée au substrat 2 en matière isolante par une succession de zones 4, séparées les unes des autres, et disposées en rangées successives, comme cela est clairement compréhensible à la vue des figures 1, 2 et 2a, constituées par des dépôts très minces d'une seconde matière conductrice ou semi-conductrice ayant un pouvoir thermoélectrique différent de celui de la première matière conductrice ou semi-conductrice.

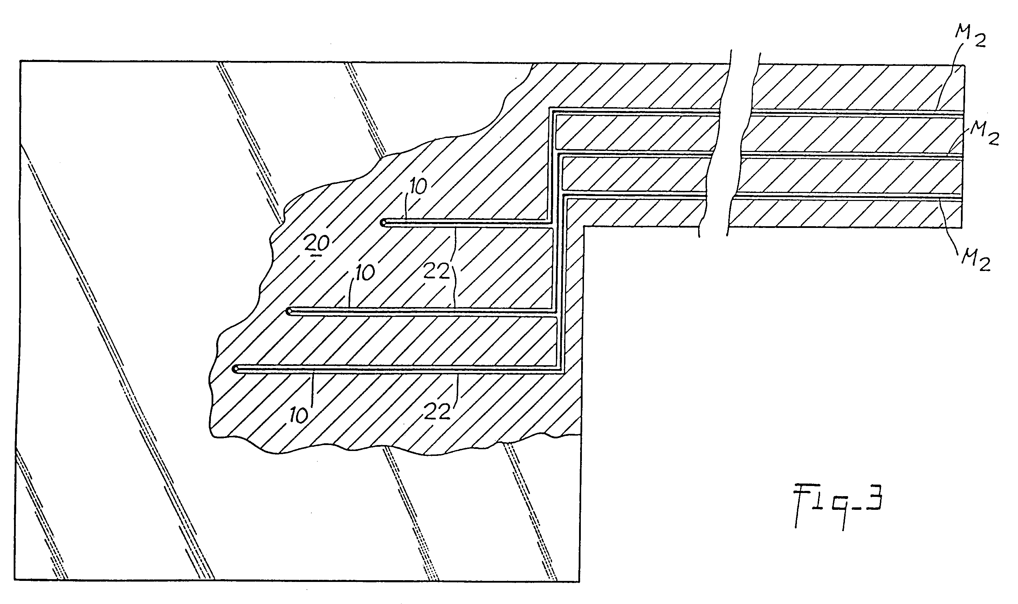

Cette structure multicouche est caractérisée selon l'invention en ce que le substrat isolant 2 comprend sur sa face 2a comportant la couche mince ininterrompue 3 un certain nombre d'espaces libres 6 dans au moins certains desquels sont réalisés un certain nombre de premiers motifs métalliques 8, que l'on voit bien à la figure 1, en une troisième matière conductrice ou semi-conductrice, constituant une première branche d'un thermocouple ;
- un nombre égal de seconds motifs 10, représentés en traits fantômes à la figure 1 et clairement visibles à la figure 3, métalliques réalisés en une quatrième matière conductrice ou semi-conductrice ayant un pouvoir thermoélectrique différent de celui de la troisième matière conductrice ou semi-conductrice correspondant, constituant une deuxième branche d'un thermocouple, est disposé sur la face 2b du substrat isolant 2 opposée à la couche mince du premier motif 8 ; chaque premier motif 8 est en contact électrique avec un second motif 10 correspondant par une soudure métallique ponctuelle 12 réalisée dans un orifice 14 traversant au moins ledit premier motif 8 et le substrat en matière isolante 2.

Selon un mode de réalisation particulier, tel que représenté, la couche mince ininterrompue 3 a la forme d'une bande méandriforme et définit ainsi des rangées successives. En outre, selon un mode de réalisation préféré représenté, au moins un canal 16 traverse de part en part au moins la plupart des zones 4 et la couche mince sous-jacente 3, ces canaux 16 étant décalés par rapport au centre C de chaque zone traversée.

Selon une autre variante, la soudure précitée 12 du premier motif 8 avec le second motif 10 est réalisée par métallisation et de préférence recouvre le premier motif 8 sur une surface déterminée 15 autour de l'orifice 14, ce qui permet d'assurer une bonne liaison mécanique de la soudure 12 avec le premier motif 8. Avantageusement, la soudure métallique 12 est réalisée en même matériau conducteur que la deuxième matière conductrice ou semi-conductrice précitée constituant les zones 4.

Selon une autre réalisation de l'invention, la troisième matière conductrice ou semi-conductrice précitée constituant les premiers motifs 8 et la première matière conductrice ou semiconductrice constituant la couche mince ininterrompue 3 sont réalisées en la même matière conductrice ou semi-conductrice.

Selon une autre réalisation de la structure multicouche selon l'invention, celle-ci comprend une feuille mince métallique 20 en une cinquième matière conductrice ou semiconductrice ayant un pouvoir thermoélectrique différent de celui de la première matière conductrice ou semi-conductrice, en étant de préférence identique à la seconde matière conductrice ou semiconductrice. Cette feuille 20 est appliquée contre l'autre face 2b du substrat en matière isolante 2 opposée à la face 2a comportant la couche ininterrompue 3 avec les zones 4 précitées. Cette feuille 20 comporte des espaces 22 pour les seconds motifs 10 précités.

Avantageusement, les seconds motifs 10 sont réalisés en la même matière conductrice ou semi-conductrice que la feuille 20.

Selon le mode de réalisation, représenté à la figure 1, une nouvelle feuille 24 de matière isolante, c'est-à-dire non conductrice de l'électricité ou diélectrique, est appliquée contre les zones 4. Cette feuille 24 en matière isolante est de préférence recouverte elle-même sur sa face libre opposée d'une feuille 26 métallique en une sixième matière conductrice ou semi-conductrice qui est avantageusement identique à la cinquième matière conductrice ou semi-conductrice, c'est-à-dire que cette feuille 26 est réalisée en une matière conductrice ou semiconductrice identique à celle de la feuille 20.

Selon un mode de réalisation encore davantage préféré, la couche mince 3 et les premiers motifs 8 sont réalisés en constantan, tandis que la feuille 20 et les seconds motifs 10 sont réalisés en cuivre, tandis que le substrat 2 en matière isolante ainsi que la feuille 24 en matière isolante peuvent être réalisés en un polyimide commercialisé sous la marque Kapton®.

On soulignera ici que, de préférence, les canaux 16 des zones 4 sont décalés en sens opposé entre deux rangées successives ou adjacentes, comme cela est clairement visible à la figure 2a. Cette structure multicouche peut être ainsi utilisée pour constituer un dispositif de mesure formant un fluxmètre et un capteur de température combinés, dans lequel les extrémités $E_1$ et $S_1$ de la couche mince ininterrompue 3 sont reliées entre elles par l'intermédiaire d'un appareillage formant fluxmètre et mesurant la force électromotrice en fonction du flux thermique traversant le matériau composite 1, tandis que les extrémités $M_1$ correspondantes des premiers motifs 8 sont reliées aux extrémités $M_2$ des seconds motifs 10 par un appareillage formant détecteur de température et mesurant la force électromotrice en fonction de la température. Le procédé de préparation de cette structure multicouche, flexible, telle que précédemment décrite de manière générale et en référence à l'exemple de réalisation préféré avec le constantan et le cuivre comme étant les deux seules matières conductrices ou semi-conductrices utilisées, est le suivant :

- on prévoit un substrat 2 en matière isolante, non conductrice de l'électricité, sous forme d'une feuille flexible ;
- on applique sur la face 2a une feuille de constantan et sur la face opposée 2b une feuille de cuivre ;
- on appose des masques déterminés sur chacune des feuilles de constantan et de cuivre, par exemple formés par une couche protectrice en résine photosensible inerte vis-à-vis d'une solution d'attaque selon la technique classique de gravure, telle que décrite à la page 6, lignes 5 à 33 de FR-A-2 536 536 ;
- on réalise l'attaque des couches par trempage de l'ensemble avec les masques dans ladite solution d'attaque, qui peut être par exemple constituée par du perchlorure de fer selon certaines lignes en définissant ainsi dans la feuille en constantan la couche ininterrompue 3 en bande méandriforme et les premiers motifs 8 et dans la feuille de cuivre les seconds motifs 10 ;
- ensuite, on dépose, par métallisation, du cuivre, toujours par la même technique de masquage, par voie électrolytique, les zones 4 précitées sur la couche ininterrompue 3 sous forme de bande méandriforme ;
- on réalise par attaque chimique, selon la technique de gravure, à l'aide de masques appropriés, les orifices 12 et les canaux 16 et on effectue un nouveau dépôt de cuivre par métallisation de manière à former un revêtement métallique à l'intérieur des orifices précités, de manière à constituer des jonctions ou contacts électriques formant des thermocouples.

Enfin, on applique sur la face 2a comportant les zones 4 une feuille en matière isolante 24 et ensuite une feuille conductrice en cuivre 26 en obtenant ainsi la structure multicouche représentée en vue éclatée à la figure 1.

**Revendications**

1. Dispositif de mesure formant un fluxmètre et un capteur de température combinés, constitué d'une structure multicouche, comprenant un substrat (2) en matière isolante sur une face duquel est déposée une couche mince ininterrompue (3) en une première matière conductrice ou semi-conductrice recouverte sur au moins sa face (3a) opposée audit substrat (2) en matière isolante par une succession de zones (4), séparées les unes des autres, et disposées en rangées successives, constituées par des dépôts très minces d'une deuxième matière conductrice ou semi-conductrice ayant un pouvoir thermoélectrique différent de celui de la première matière conductrice ou semi-conductrice, caractérisé en ce que ledit substrat en matière isolante (2) comprend sur sa face (2a) comportant ladite couche mince ininterrompue (3) un certain nombre d'espaces libres (6) dans au moins certains desquels sont réalisés un certain nombre de premiers motifs métalliques (8) en une troisième matière conductrice ou semi-conductrice constituant une première branche d'un thermocouple, un nombre, égal de seconds motifs (10) métalliques en une quatrième matière conductrice ou semi-conductrice à pouvoir thermoélectrique différent de celui de la troisième matière conductrice ou semi-conductrice, correspondant, constituant une deuxième branche d'un thermocouple, est disposé sur la face du substrat isolant (2) opposée à la couche mince (3) ininterrompue et aux premiers motifs (8), chaque premier motif (8) est en contact avec un second motif (10) correspondant par une soudure métallique ponctuelle (12) réalisée dans un orifice (14) traversant au moins ledit premier motif (8) et ledit substrat (2).

**2.** Dispositif selon la revendication 1, caractérisé en ce que la soudure précitée (12) est réalisée par métallisation et recouvre le premier motif (8) sur une surface déterminée (15) autour de l'orifice (14).

**3.** Dispositif selon la revendication 1 ou 2, caractérisé en ce que la troisième matière conductrice ou semi-conductrice constituant les premiers motifs (8) et la première matière conductrice ou semi-conductrice constituant la couche mince ininterrompue (3) sont réalisées en la même matière conductrice ou semi-conductrice.

**4.** Dispositif selon l'une quelconque des revendications 1 à 3, caractérisé en ce que la soudure métallique (12) précitée est réalisée en la même matière conductrice ou semi-conductrice que la deuxième matière conductrice ou semi-conductrice constituant les zones (4) précitées.

**5.** Dispositif selon l'une quelconque des revendications 1 à 4, caractérisé en ce qu'il comprend une feuille mince en une cinquième matière conductrice ou semi-conductrice appliquée contre l'autre face (2b) du substrat isolant (2) opposée à la face (2a) comportant la couche mince ininterrompue (3) avec les zones (4) précitées, comportant des espaces (22) pour les seconds motifs (10) précités.

**6.** Dispositif selon la revendication 5, caractérisé en ce que les seconds motifs précités (10) sont réalisés en la même matière conductrice ou semi-conductrice que la feuille (20).

**7.** Dispositif selon l'une des revendications 5 ou 6, caractérisé en ce que la couche mince ininterrompue (3) précitée des premiers motifs (8) est en constantan et la feuille (20) et les seconds motifs (10) sont en cuivre.

**8.** Dispositif selon l'une des revendications 5 à 7, caractérisé en ce qu'il comprend une feuille (24) en matière isolante, non conductrice de l'électricité, appliquée contre les zones (4) précitées, cette feuille en matière isolante étant recouverte d'une feuille (26) en une sixième matière conductrice ou semi-conductrice qui est identique à la cinquième matière conductrice ou semi-conductrice.

**9.** Dispositif selon l'une quelconque des revendications précédentes, caractérisé en ce que la couche mince ininterrompue précitée (3) a la forme d'une bande méandriforme et définit ainsi les rangées successives précitées ; au moins un canal (16) traverse de part en part au moins la plupart des zones (4) et la couche mince sous-jacente (3), ces canaux étant décalés du centre (C) de chaque zone traversée.

**10.** Dispositif selon l'une quelconque des revendications 1 à 9, caractérisé en ce que la structure multicouche précitée est flexible par l'emploi d'un substrat flexible.

**11.** Dispositif selon l'une quelconque des revendications 1 à 10, caractérisé en ce que les extrémités ($E_1$, $S_1$) de la couche mince ininterrompue (3) sont reliées entre elles par l'intermédiaire d'un appareillage formant fluxmètre et mesurant la force électromotrice en fonction du flux thermique traversant la structure multicouche (1), tandis que les extrémités ($M_1$) des premiers motifs (8) sont reliées aux extrémités des seconds motifs ($M_2$) par un appareillage formant détecteur de température et mesurant la force électromotrice en fonction de la température.

**12.** Procédé de préparation de la structure multicouche utilisée dans le dispositif de mesure selon l'une quelconque des revendications 1 à 11, comprenant:
   - la prévision d'un substrat (2) en matière isolante sous forme d'une feuille ;
   - l'application sur une face (2a) dudit substrat (2) d'une première couche mince continue (3) en une première matière conductrice ou semi-conductrice ;
   - l'apposition de masques déterminés sur ladite première couche recouvrant le substrat (2), en définissant ainsi des lignes d'attaque de ladite couche ;
   - l'attaque de ladite couche par trempage de l'ensemble avec les masques dans une solution d'attaque par la technique classique de gravure de manière à attaquer la première couche selon certaines lignes en définissant ainsi dans la première couche une couche ininterrompue (3) ;
   - le dépôt par métallisation, sur au moins la face (3a) de ladite couche mince ininterrompue (3) opposée au substrat (2), d'une succession de zones (4), séparées les unes des autres, et disposées en rangées successives, constituées par des dépôts très minces d'une deuxième matière conductrice ou semi-conductrice ayant un pouvoir thermoélectrique différent de celui de la première matière conductrice ou semi-conductrice ;

caractérisé en ce qu'on réalise l'attaque de ladite première couche avec des masques selon des lignes définissant dans la première couche, outre ladite couche ininterrompue (3), un certain nombre d'espaces libres (6) dans au moins certains desquels sont réalisés un certain nombre de premiers motifs métalliques (8) en une troisième matière conductrice ou semi-conductrice constituant une première branche d'un thermocouple, on applique sur l'autre face (26) du substrat (2) opposée à la première couche (3) une deuxième couche mince continue (20) en une quatrième matière conductrice ou semi-conductrice à pouvoir thermoélectrique différent de celui-ci de la troisième matière conductrice ou semi-conductrice, on réalise l'attaque de la deuxième couche avec les masques selon les lignes définissant, lors de la deuxième couche (20), un nombre égal de seconds motifs (10) métalliques en ladite quatrième matière conductrice ou semi-conductrice, constituant une deuxième branche d'un thermocouple, dans des espaces libres (22) correspondants ;

- on réalise des orifices (14) traversant au moins tes premiers motifs (8) et le substrat en matière isolante (2) ; et
- on réalise une soudure métallique ponctuelle (12) dans les orifices (14) mettant en contact chaque premier motif (8) avec un second motif (10) correspondant.

13. Procédé selon la revendication 12, caractérisé en ce qu'on applique sur la face (3) comportant les zones (4) une feuille (24) en matière isolante, non conductrice de l'électricité, et ensuite une feuille conductrice (26) ou semi-conductrice en une cinquième matière conductrice ou semi-conductrice.

14. structure multicouche, comprenant un substrat (2) en matière isolante sur une face duquel est déposée une couche mince ininterrompue (3) en une première matière conductrice ou semi-conductrice recouverte sur au moins sa face (3a) opposée audit substrat (2) en matière isolante par une succession de zones (4), séparées tes unes des autres, et disposées en rangées successives, constituées par des dépôts très minces d'une seconde matière conductrice ou semi-conductrice ayant un pouvoir thermoélectrique différent de celui de ta première matière conductrice ou semiconductrice, caractérisée en ce que ledit substrat en matière isolante (2) comprend sur sa face (2a) comportant ladite couche mince ininterrompue (3) un certain nombre d'espaces libres (6) dans au moins certains desquels sont réalisés un certain nombre de premiers motifs métalliques (8) en une troisième matière conductrice ou semi-conductrice constituant une première branche d'un thermocouple, un nombre égal de seconds motifs (10) métalliques correspondant en une quatrième matière conductrice ou semi-conductrice à pouvoir thermoélectrique différent de celui de la troisième matière conductrice ou semi-conductrice, constituant une deuxième branche d'un thermocouple, est disposé sur la face du substrat isolant (2) opposée à la couche mince (3) ininterrompue et aux premiers motifs (8), chaque premier motif (8) est en contact avec un second motif (10) correspondant par une soudure métallique ponctuelle (12) réalisée dans un orifice (14) traversant au moins ledit premier motif (8) et ledit substrat en matière isolante (2).

## Claims

1. Measuring device forming a fluxmeter and a temperature sensor combined, constituted by a multi-layer structure, comprising a substrate (2) of insulating matter on one face of which is deposited an uninterrupted thin layer (3) of a first conductive or semi-conductive matter coated on at least its face (3a) opposite said substrate (2) of insulating matter by a succession of zones (4), separated from one another and disposed in successive rows, constituted by very thin deposits of a second conductive or semi-conductive matter having a different thermoelectric capacity from that of the first conductive or semi-conductive matter, characterized in that said substrate (2) of insulating matter comprises on its face (2a) comprising said uninterrupted thin layer (3) a certain number of free spaces (6) in at least certain of which are made a certain number of first metal patterns (8) of a third conductive or semi-conductive matter constituting a first arm of a thermocouple, an equal number of second metal patterns (10) of a fourth conductive or semi-conductive matter with a thermoelectric capacity different from that of the corresponding third conductive or semi-conductive matter, constituting a second arm of a thermocouple, is disposed on that face of the insulating substrate (2) opposite the uninterrupted thin layer (3) and the first patterns (8), each first pattern (8) is in contact with a corresponding second pattern (10) by a metal spot welding (12) made in an orifice (14) passing through at least said first pattern (8) and said substrate (2).

2. Device according to claim 1, characterized in that said welding (12) is effected by metallization and covers the first pattern (8) over a determined surface (15) around the orifice (14).

3. Device according to claim 1 or 2, characterized in that the third conductive or semi-conductive matter constituting the first patterns (8) and the first conductive or semi-conductive matter constituting the uninterrupted thin layer (3) are made of the same conductive or semi-conductive matter.

4. Device according to any one of claims 1 to 3, characterized in that said metal welding (12) is made of the same conductive or semi-conductive matter as the second conductive or semi-conductive matter constituting the zones (4) mentioned above.

5. Device according to any one of claims 1 to 4, characterized in that it comprises a thin sheet (20) of a fifth conductive or semi-conductive matter applied against the other face (2b) of the insulating substrate (2) opposite the face (2a) comprising the uninterrupted thin layer (3) with the said zones (4) comprising spaces (22) for the second patterns (10) mentioned above.

6. Device according to claim 5, characterized in that said second patterns (10) are made of the same conductive or semi-conductive matter as the sheet (20).

7. Device according to one of claims 5 or 6, characterized in that said uninterrupted thin layer (3) of the first patterns (8) is made of Constantan, whilst the sheet (20) and the second patterns (10) are made of copper.

8. Device according to one of claims 5 to 7, characterized in that it comprises a sheet (24) of insulating matter, non-conductive of electricity, applied against the zones (4) mentioned above, this sheet of insulating matter being coated with a sheet 26 of a sixth conductive or semi-conductive matter which is identical to the fifth conductive or semiconductive matter.

9. Device according to any one of the preceding claims, characterized in that said uninterrupted thin layer (3) has the shape of a meandering strip and thus defines the said successive rows ; at least one channel (16) passes right through at least the majority of the zones (4) and the subjacent thin layer (3), these channels being offset with respect to the centre (C) of each zone traversed.

10. Device according to any one of claims 1 to 9, characterized in that said multi-layer structure is flexible due to the use of a flexible substrate.

11. Device according to any one of claims 1 to 10, characterized in that the ends ($E_1$, $S_1$) of the uninterrupted thin layer (3) are connected together via an apparatus forming fluxmeter and measuring the electromotive force as a function of the thermal flux passing through the multi-layer structure (1) , whilst the ends ($M_1$) of the first patterns (8) are connected to the ends ($M_2$) of the second patterns by an apparatus forming temperature detector and measuring the electromotive force as a function of the temperature.

12. Process for preparing a multi-layer structure used in the measuring device according to any one of claims 1 to 11, process comprising the steps of:
   - providing a substrate (2) of insulating matter, in the form of a sheet;
   - applying on one face (2a) of said substrate (2) a first continuous thin layer (3) made of a first conductive or semi-conductive matter;
   - posing determined masks on said first layer coating the substrate (2), thus defining lines of attack of said layer;
   - etching said layer by immersing the whole with the masks in an etching solution by the conventional engraving technique so as to etch the first layer along certain lines, thus defining in the first layer an uninterrupted layer (3);
   - depositing by metallization on at least one face (3a) of said uninterrupted thin layer (3) , opposite the substrate (2) a succession of zones (4), separated from one another, and disposed in successive rows, constituted by very thin deposits of a second conductive or semi-conductive matter having a different thermoelectric capacity from that of the first conductive or semi-conductive matter;
   characterized in that etching of said first layer is effected with masks along lines defining in the first layer, in addition to said uninterrupted layer (3), a certain number of free spaces (6) in at least certain of which are made a certain number of first metal patterns (8) of a third conductive or semi-conductive matter,

constituting a first arm of a thermocouple, a second continuous thin layer (20) of a fourth conductive or semi-conductive matter with a thermoelectric capacity different from that of the third conductive or semi-conductive matter is applied against the other face (26) of the substrate (2) opposite the first layer (3), etching of the second layer is effected with the masks along the lines defining, in the second layer (20), an equal number of second metal patterns (10) of said fourth conductive or semi-conductive matter constituting a second arm of a thermocouple, in corresponding free spaces (22);

- orifices (14) passing through at least the first patterns (8) and the substrate of insulating substrate (2) are made ; and
- a metal spot welding (12) is made in the orifices (14) bringing into contact each first pattern (8) with a corresponding second pattern (8).

13. Process according to claim 12, characterized in that a sheet (24) of insulating matter, non-conductive of electricity is applied against the face (3) comprising the zones (4) and then a conductive or semi-conductive sheet (26) of a fifth conductive or semi-conductive matter.

14. Multi-layer structure, comprising a substrate (2) of insulating matter on one face of which is deposited an uninterrupted thin layer (3) of a first onductive or semi-conductive matter coated on at least its face (3a) opposite said substrate (2) of insulating matter by a succession of zones (4), separated from one another and disposed in successive rows, constituted by very thin deposits of a second conductive or semi-conductive matter having a different thermoelectric capacity from that of the first conductive or semi-conductive matter, characterized in that said substrate (2) of insulating matter comprises on its face (2a) comprising said uninterrupted thin layer (3) a certain number of free spaces (6) in at least certain of which are made a certain number of first metal patterns (8) of a third conductive or semi-conductive matter, constituting a first arm of a thermocouple, an equal number of corresponding second metal patterns (10) Of a fourth conductive or semi-conductive matter with a thermoelectric capacity different from that of the third conductive or semi-conductive matter, constituting a second arm of a thermocouple, is disposed on the face of the insulating substrate (2) opposite the uninterrupted thin layer (3) and the first patterns (8), each first pattern (8) is in contact with a corresponding second pattern (10) by a metal spot welding (12) made in an orifice (14) passing through at least said first pattern (8) and said substrate (2) of insulating matter.

**Patentansprüche**

1. Einen Flußdichtemesser und einen Temperaturfühler in Kombination bildende Meßeinrichtung, bestehend aus einer Mehrschichtstruktur mit einem Substrat (2) aus isolierendem Material, auf dessen einer Seite eine dünne ununterbrochene Schicht (3) aus einem ersten leitenden oder halbleitenden Material aufgebracht ist, die zumindest an ihrer dem Substrat (2) aus isolierendem Material gegenüberliegenden Seite (3a) mit einer Folge von voneinander getrennten und in aufeinanderfolgenden Reihen angeordneten Zonen (4) überzogen ist, bestehend aus sehr dünnen Niederschlägen eines zweiten leitenden oder halbleitenden Materials mit einer Thermospannung, die sich von jener des ersten leitenden oder halbleitenden Materials unterscheidet, dadurch gekennzeichnet, daß das Substrat aus isolierendem Material (2) auf seiner die dünne ununterbrochene Schicht (3) umfassenden Seite (2a) eine bestimmte Anzahl von Leiterabständen (6) aufweist, von denen in zumindest einigen eine gewisse Anzahl an ersten metallischen Mustern (8) aus einem dritten leitenden oder halbleitenden Material ausgebildet sind, die einen ersten Zweig eines Thermoelements bilden, daß eine entsprechende gleiche Anzahl an zweiten metallischen Mustern (10) aus einem vierten leitenden oder halbleitenden Material mit einer Thermospannung, die sich von jener des dritten leitenden oder halbleitenden Materials unterscheidet, welche einen zweiten Zweig eines Thermoelements bilden, auf der der dünnen ununterbrochenen Schicht (3) und den ersten Mustern (8) gegenüberliegenden Seite des isolierenden Substrats (2) angeordnet sind, und daß jedes erste Muster (8) mit einem entsprechenden zweiten Muster (10) über eine punktförmige metallische Schweißnaht (12) in Kontakt steht, die in einer durch zumindest das erste Muster (8) und das Substrat (2) gehenden Öffnung (14) hergestellt ist.

2. Vorrichtung nach Anspruch 1, dadurch gekennzeichnet, daß die genannte Schweißnaht (12) durch Metallisierung hergestellt ist und das erste Muster (8) über eine bestimmte Oberfläche (15) rund um die Öffnung (14) überdeckt.

3. Vorrichtung nach Anspruch 1 oder 2, dadurch gekennzeichnet, daß das die ersten Muster (8) bildende dritte leitende oder halbleitende Material und das die dünne ununterbrochene Schicht (3) bildende erste leitende oder halbleitende Material aus demselben leitenden oder halbleitenden Material hergestellt sind.

4. Vorrichtung nach einem der Ansprüche 1 bis 3, dadurch gekennzeichnet, daß die metallische Schweißnaht (12) aus demselben leitenden oder halbleitenden Material wie das die Zonen (4) bildende zweite leitende oder halbleitende Material hergestellt ist.

5. Vorrichtung nach einem der Ansprüche 1 bis 4, dadurch gekennzeichnet, daß sie eine dünne Folie (20) aus einem fünften leitenden oder halbleitenden Material umfaßt, die auf der anderen, der die dünne ununterbrochene Schicht (3) mit den Zonen (4) umfassenden Seite (2a) gegenüberliegenden Seite (2b) des isolierenden Substrats (2) aufgebracht ist und Leiterabstände (22) für die zweiten Muster (10) umfaßt.

6. Vorrichtung nach Anspruch 5, dadurch gekennzeichnet, daß die zweiten Muster (10) aus demselben leitenden oder halbleitenden Material wie die Folie (20) hergestellt sind.

7. Vorrichtung nach einem der Ansprüche 5 oder 6, dadurch gekennzeichnet, daß die dünne ununterbrochene Schicht (3) der ersten Muster (8) aus Konstantan ist und die Folie (20) und die zweiten Muster (10) aus Kupfer sind.

8. Vorrichtung nach einem der Ansprüche 5 bis 7, dadurch gekennzeichnet, daß sie eine Folie (24) aus elektrisch nichtleitendem isolierendem Material umfaßt, die an den Zonen (4) aufgebracht ist, welche Folie aus isolierendem Material mit einer Folie (26) aus einem sechsten leitenden oder halbleitenden Material überzogen ist, das identisch mit dem fünften leitenden oder halbleitenden Material ist.

9. Vorrichtung nach einem der vorhergehenden Ansprüche, dadurch gekennzeichnet, daß die dünne ununterbrochende Schicht (3) die Form eines meanderförmigen Bandes hat und so die besagten aufeinanderfolgenden Reihen festlegt, daß zumindest ein Kanal (16) zumindest durch die meisten der Zonen (4) und die darunterliegende dünne Schicht (3) durch und durch geht, wobei diese Kanäle zum Mittelpunkt (C) jeder durchsetzten Zone versetzt sind.

10. Vorrichtung nach einem der Ansprüche 1 bis 9, dadurch gekennzeichnet, daß die Mehrschichtstruktur durch den Einsatz eines flexiblen Substrats flexibel ist.

11. Vorrichtung nach einem der Ansprüche 1 bis 10, dadurch gekennzeichnet, daß die Enden $(E_1, S_1)$ der dünnen ununterbrochenen Schicht (3) über eine einen Flußdichtemesser bildende Apparatur, die die Thermospannung als Funktion des durch die Mehrschichtstruktur (1) gehenden Wärmeflusses mißt, miteinander verbunden sind, während die Enden $(M_1)$ der ersten Muster (8) mit den Enden $(M_2)$ der zweiten Muster über eine Apparatur, die einen Temperaturfühler bildet und die elektromotorische Kraft als Funktion der Temperatur mißt, verbunden sind.

12. Verfahren zur Herstellung der in der Meßvorrichtung nach einem der Ansprüche 1 bis 11 verwendeten Mehrschichtstruktur, umfassend:
   - die Vorsehung eines Substrats (2) aus isolierendem Material in Folienform;
   - die Aufbringung einer ersten durchgehenden dünnen Schicht (3) aus einem ersten leitenden oder halbleitenden Material auf eine Seite (2a) des Substrats (2);
   - die Anbringung von bestimmten Masken auf die erste, das Substrat (2) überdeckende Schicht unter Festlegung von Ätzlinien der Schicht auf diese Weise;
   - die Ätzung der Schicht durch Eintauchen des Ganzen mit den Masken in eine Ätzlösung mittels der klassischen Gravurtechnik, sodaß die erste Schicht entlang gewisser Linien geätzt wird und so in der ersten Schicht eine ununterbrochene Schicht (3) festgelegt wird;
   - die Herstellung einer Folge von Zonen (4) auf zumindest der Seite (3a) der dünnen ununterbrochenen Schicht (3) gegenüber dem Substrat (2) durch Metallisierung, welche voneinander getrennt und in aufeinanderfolgenden Reihen angeordnet sind, bestehend aus sehr dünnen Niederschlägen eines zweiten leitenden oder halbleitenden Materials mit einer Thermospannung, die sich von jener des ersten leitenden oder halbleitenden Materials unterscheidet; dadurch gekennzeichnet, daß
   - man die Ätzung der ersten Schicht mit Masken entlang Linien vornimmt, die in der ersten Schicht neben der ununterbrochenen Schicht (3) eine bestimmte Anzahl an Leiterabständen (6) festlegen, von denen in zumindest einigen eine gewisse Anzahl an ersten metallischen Mustern (8) aus einem dritten leitenden oder halbleitenden Material gebildet werden, die einen ersten Zweig eines Thermoelements bilden, man auf die andere Seite (26) des Substrats (2) gegenüber der ersten Schicht (3) eine zweite dünne durchgehende Schicht (20) aus einem vierten leitenden oder halbleitenden Material mit einer Thermospannung, die sich von jener des dritten leitenden oder halbleitenden Materials unterscheidet, aufbringt, man die Ätzung der zweiten Schicht mit den Masken entlang der Linien vornimmt, die bei der zweiten Schicht (20) in den entsprechenden Leiterabständen (22) eine gleiche Anzahl an zweiten metallischen Mustern (10) aus dem vierten leitenden oder halbleitenden Material festlegen, welche einen zweiten Zweig eines Thermoelements bilden;

- man Öffnungen (14) einarbeitet, die zumindest durch die ersten Muster (8) und das Substrat aus isolierendem Material (2) gehen; und
- man eine punktförmige metallische Schweißnaht (12) in den Öffnungen (14) herstellt und so jedes erste Muster (8) mit einem entsprechenden zweiten Muster (10) in Kontakt bringt.

**13.** Vorrichtung nach Anspruch 12, dadurch gekennzeichnet, daß man auf die die Zonen (4) umfassende Seite (3) eine Folie (24) aus elektrisch nichtleitendem, isolierendem Material und danach eine leitende oder halbleitende Folie (26) aus einem fünften leitenden oder halbleitenden Material aufbringt.

**14.** Mehrschichtstruktur, umfassend ein Substrat (2) aus isolierendem Material, auf dessen einer Seite eine dünne ununterbrochene Schicht (3) aus einem ersten leitenden oder halbleitenden Material aufgebracht ist, die zumindest an ihrer dem Substrat (2) aus isolierendem Material gegenüberliegenden Seite (3a) mit einer Folge von voneinander getrennten und in aufeinanderfolgenden Reihen angeordneten Zonen (4) überzogen ist, bestehend aus sehr dünnen Niederschlägen eines zweiten leitenden oder halbleitenden Materials mit einer Thermospannung, die sich von jener des ersten leitenden oder halbleitenden Materials unterscheidet, dadurch gekennzeichnet, daß das Substrat aus isolierendem Material (2) auf seiner die dünne ununterbrochene Schicht (3) umfassenden Seite (2a) eine bestimmte Anzahl von Leiterabständen (6) aufweist, von denen in zumindest einigen eine gewisse Anzahl an ersten metallischen Mustern (8) aus einem dritten leitenden oder halbleitenden Material ausgebildet sind, die einen ersten Zweig eines Thermoelements bilden, daß eine entsprechende gleiche Anzahl an zweiten metallischen Mustern (10) aus einem vierten leitenden oder halbleitenden Material mit einer Thermospannung, die sich von jener des dritten leitenden oder halbleitenden Materials unterscheidet, welche einen zweiten Zweig eines Thermoelements bilden, auf der der dünnen ununterbrochenen Schicht (3) und den ersten Mustern (8) gegenüberliegenden Seite des isolierenden Substrats (2) angeordnet sind, und daß jedes erste Muster (8) mit einem entsprechenden zweiten Muster (10) über eine punktförmige metallische Schweißnaht (12) in Kontakt steht, die in einer durch zumindest das erste Muster (8) und das Substrat (2) aus isolierendem Material gehenden Öffnung (14) hergestellt ist.

Fig_1

EP 0 269 485 B1

Fig-2a

Fig-2

Fig-3